# EUROPÄISCHE PATENTSCHRIFT

(11) **EP 0 232 497 B1**
(45) Veröffentlichungstag und Bekanntmachung des Hinweises auf die Patenterteilung: **10.03.1993**
(21) Anmeldenummer: 86116737.7
(22) Anmeldetag: 02.12.1986
(51) Int. Cl.: H01L 21/82, H01L 21/28, H01L 27/06

(54) **Verfahren zum gleichzeitigen Herstellen von bipolaren und komplementären MOS-Transistoren auf einem gemeinsamen Siliziumsubstrat**
Process for simultaneous manufacturing of bipolar and complementary MOS-transistors on a common silicon substrate
Procédé pour la fabrication simultanée de transistors bipolaires et MOS-complémentaires sur un substrat commun en silicium

(30) Priorität: 17.12.1985 DE 3544638
(43) Veröffentlichungstag der Anmeldung: 19.08.1987
(73) Patentinhaber: SIEMENS AKTIENGESELLSCHAFT, 80333 München (DE)
(72) Erfinder: Schaber, Hans-Christian, Dr., D-8032 Gräfelfing (DE)

(56) Entgegenhaltungen:
- EP-A- 0 083 785
- FR-A- 2 531 812
- IBM TECHNICAL DISCLOSURE BULLETIN, Band 24, Nr. 1B, Juni 1981, Seiten 466-470, New York, USA ; J. A. DORLER et al. : "Complementary bipolar-FET integrated circuit".
- ELEKTROTECHNIK UND MASCHINENBAU, Band 103, Nr. 1, Januar 1985 ; Seiten 34-37, Wien, Oesterreich ; P. SIEBER : "Telefunken electronic auf dem Weg zur Submikron-Technologie".
- PATENT ABSTRACTS OF JAPAN, Band 7, Nr. 36 (E-158)(1181), 15. Februar 1983 ; & JP-A-57188862

## Beschreibung

Die Erfindung betrifft ein Verfahren zum gleichzeitigen Herstellen von bipolaren und komplementären MOS-Transistoren auf einem gemeinsamen Substrat, bei dem für die Aufnahme der p-Kanal-Transistoren im p-dotierten Siliziumsubstrat n-dotierte Bereiche erzeugt werden und in die n-dotierten Bereiche isolierte npn-Bipolar-Transistoren gelegt werden, wobei die n-Bereiche den Kollektor des Transistors bilden und bei dem die n-Bereiche vergrabene n⁺-dotierte Zonen bedecken, die in Bipolar-Transistor-Bereichen durch tiefreichende Kollektoranschlüsse angeschlossen werden.

Ein solches Verfahren für eine 1,0 µm Wannen-CMOS/Bipolar-Technik für höchstintegrierte Schaltungen ist beispielsweise aus einem Aufsatz von Miyamoto et. al. aus dem IEDM 1983, Technical Digest (Dezember 1983), auf den Seiten 63 bis 66, zu entnehmen. Zur Verringerung des Kollektorwiderstandes wird ein vergrabener Kollektor verwendet, der durch einen tiefen Kollektorkontakt angeschlossen wird.

Die Herstellung von Bipolar-Transistoren mit vergrabenem Kollektor und selbstjustierten Basis/Emitter-Bereichen, bei dem die Emitter- und Basiszonen durch Ausdiffusion aus dotierten Polysiliziumstrukturen gebildet werden, ist aus einem Aufsatz von H. Murrmann "Modern Bipolar Technology for High Performance ICs" aus den Siemens Forschungs- und Entwicklungsberichten, Band 5 (1976), Nr. 6, Seiten 353 bis 359, und aus einem Aufsatz von A. Wieder ("Self-aligned Bipolar Technology - New Chances for Very-High-Speed Digital Integrated Circuits" in den Siemens Forschungs- und Entwicklungsberichten, Band 13 (1984), auf den Seiten 246 bis 252, zu entnehmen. Solche Transistoren werden in LSI-Schaltungen für hohe Schaltgeschwindigkeiten verwendet.

Aufgabe der Erfindung ist es, einen Herstellungsprozeß für hochintegrierte Schaltungen mit komplementären MOS (CMOS)-Transistoren und Bipolar-Transistoren anzugeben, der größtmögliche Systemgeschwindigkeiten erlaubt. Dabei sollen CMOS-Transistoren mit kurzen Kanallängen gleichzeitig und kompatibel mit den für höchste Schaltgeschwindigkeiten besonders vorteilhaften selbstjustierten Bipolar-Transistoren in Doppel-Polysilizium-Technik, wie sie in dem obengenannten Aufsatz von A. Wieder beschrieben sind, hergestellt werden.

Die erfindungsgemäße Aufgabe wird durch ein Verfahren der eingangs genannten Art durch die im kennzeichnenden Teil des Anspruchs 1 aufgeführten Verfahrensschritte gelöst.

Weitere Ausgestaltungen der Erfindung ergeben sich aus den Unteransprüchen.

Durch das erfindungsgemäße Verfahren, welches von an und für sich bekannten Prozeßabläufen für selbstjustierte Bipolar-Transistoren ausgeht und diese so kombiniert bzw. ergänzt, daß sich damit gleichzeitig auch vorteilhaft p-Kanal- und n-Kanal-MOS-Transistoren herstellen lassen, ergeben sich folgende Vorteile:
1. Die Herstellung extrem schneller, selbstjustierter Bipolar-Transistoren in Doppel-Polysilizium-Technik (wie sie in dem Aufsatz von A. Wieder beschrieben werden) ist möglich.
2. Die Kanallängen der CMOS-Transistoren können erheblich kürzer als die Minimalstruktur der verwendeten Lithographie sein, so daß sich selbst bei konventioneller optischer Lithographie Kanallängen unterhalb von 0,5 µm herstellen lassen.
3. Die Source/- und Drain-Gebiete der CMOS-Transistoren können durch die Verwendung der Silizid- und Polyzid (= Doppelschicht aus Polysilizium und Silizid)-Schichten selbstjustiert und extrem niederohmige kontaktiert werden.
Das erfindungsgemäße Verfahren bietet daher die Möglichkeit, äußerst schnelle und hochintegrierte Schaltungen herzustellen, wobei relativ entspannte Anforderungen an die verwendete Lithographie gestellt werden.

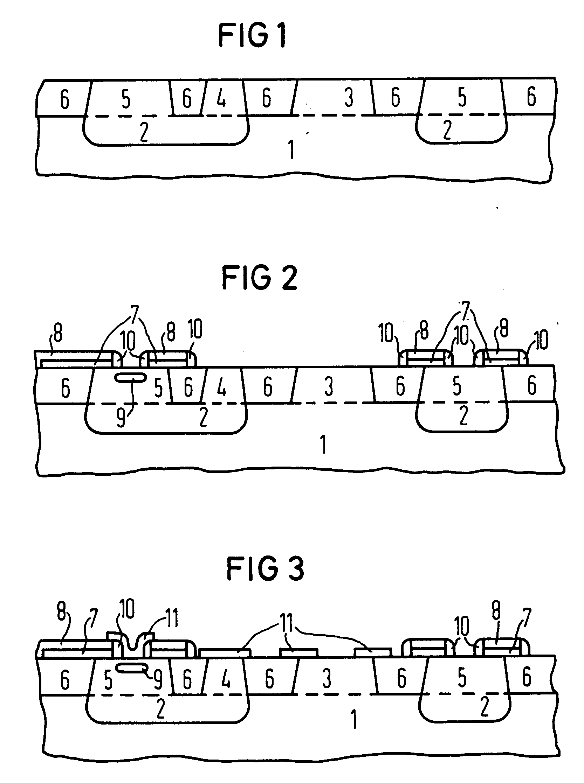

Im folgenden wird anhand der Figuren 1 bis 5 und eines Ausführungsbeispiels der Prozeßablauf noch näher beschrieben. Dabei sind in den Figuren im Schnittbild nur die erfindungswesentlichen Verfahrensschritte dargestellt; für gleiche Teile sind gleiche Bezugszeichen vorgesehen.

Figur 1: Die hier abgebildete Anordnung wird zum Beispiel durch folgende Schritte erzeugt:
a) Bildung des vergrabenen Kollektorbereiches 2 in einem p-dotierten Siliziumsubstrat 1 durch maskierte Ionenimplantation von Antimon mit einer Dosis und Energie von 3 x 10¹⁵ cm⁻² und 80 keV,
b) Abscheidung einer n-dotierten Epitaxieschicht,
c) Aufbringen einer aus Siliziumoxid und Siliziumnitrid bestehenden Doppelschicht und entsprechende Strukturierung der Siliziumnitridschicht für den nachfolgenden LOCOS-Schritt,
d) Herstellung des für die Trennung der aktiven Transistorbereiche für die Transistoren T_{A}, T_{B}, T_{C} (siehe Figur 5) im Substrat 1 erforderlichen Feldoxids 6 durch lokale Oxidation unter Verwendung der bei c) erzeugten Siliziumnitridstruktur als Oxidationsmaske,
e) Erzeugung der p-Bereiche (Wannen) 3 durch eine maskierte Bor-Ionenimplantation mit einer Dosis und Energie von 5 x 10¹² cm⁻² und 180 keV und der Bereiche für den tiefreichenden Kollektoranschluß durch eine Tiefimplantation mit Phosphorionen bei einer Dosis und Energie von 3 x 10¹⁵ cm⁻² und 80 keV und Eindiffusion, wobei auch der Kollektoranschluß 4 bis zum Kollektorbereich 2 eingetrieben wird, und
f) Entfernen der Nitrid/Oxid-Maske.

Im Bedarfsfall können unter den Feldoxidbereichen 6 auch sogenannte "channel-stopper"-Bereiche (21) durch Bor-Ionenimplantation erzeugt werden (Näheres siehe Figur 5).

Figur 2: Die p⁺-lietende Schichtstruktur 7 mit der darüberliegenden Isolatorschicht 8 wird durch ganzflächiges Aufbringen und Strukturieren der beiden Schichten mit senkrechten Flanken nach erfolgter Photolacktechnik mittels eines Trockenätzverfahrens, zum Beispiel durch reaktives Ionenätzen in einem Trifluormethan-Sauerstoff-Gasgemisch, um die vorzugsweise aus SiO₂ bestehende Isolatorschicht (8) zu entfernen und durch Plasma-Ätzen in Tetrachlorkohlenstoff-Helium, um die aus vorzugsweise bordotiertem Polysilizium bestehende Schicht (7) zu strukturieren, erzeugt. Durch die Strukturen 7, die sich direkt auf der Substratoberfläche befinden, wird der Basisbereich der Bipolar-Transistoren T_{A} und die Source/Drain-Zonen bzw. Anschlüsse der p-Kanal-Transistoren T_{C} festgelegt. Die p-leitende Schichtstruktur 7, die auch aus Silizid oder Polyzid bestehen kann, wobei die Bordotierung während und auch nach der Abscheidung erfolgen kann, dient als Diffusionsquelle bei der Erzeugung der Basiszone sowie der Source/Drain-Zonen des p-Kanal-Transistors T_{C}. Nach Strukturierung der Doppelschicht 7, 8 mit den senkrechten Flanken, wobei das Substrat möglichst wenig angeätzt werden sollte (weniger als 50 nm), erfolgt nach durchgeführter Photolacktechnik die Implantation des aktiven Basisbereiches 9 mit Bor-Ionen. Schließlich wird eine gut kantenbedeckende Isolationsschicht, vorzugsweise aus SiO₂ (spacer oxid 1) ganzflächig aufgebracht und durch eine anisotrope Ätzung, zum Beispiel durch reaktives Ionenätzen in einen Trifluormethan-Suaerstoff-Gasgemisch (CHF₃/O₂) so strukturiert, daß nur an den Flanken der p-leitenden Schichtstruktur 7 (8) laterale Isolationsstege 10 stehenbleiben.

Figur 3: Es erfolgt die ganzflächige Abscheidung einer n⁺-leitenden Schicht (11) aus Polysilizium, wobei eine relativ hohe Arsendotierung (größer 10²⁰ cm⁻³) vorzugsweise während der CVD (= chemical vapor deposition)-Abscheidung eingebracht wird. Dies ist notwendig, um einen möglichst abrupten Abfall der Arsen-Konzentration an der Grenzfläche zum Substrat zu erreichen. Die dotierte Polysiliziumschicht (11) kann durch eine Silizidschicht verstärkt werden, wodurch bei der späteren Kontaktierung möglichst niederohmige Anschlüsse entstehen. Durch eine maskierte zusätzliche Phosphor-Implantation in die Schicht 11 kann in den Bereichen der n-Kanal-Transistoren B ein weicher pn-Übergang im Drain-Gebiet erzeugt werden (in der Figur nicht dargestellt).

Mittels Photolithographie wird die arsendotierte Schicht 11 so strukturiert, daß die Source/Drain-Anschlüsse der n-Kanal-Transistoren T_{B} und der Emitter- und Kollektoranschluß der Bipolar-Transistoren T_{A} auf dem Substrat (1) gebildet werden. Dabei sind senkrechte Flanken, wie bei Figur 2 beschrieben, nicht erforderlich; die Anätzung des Substrates sollte aber wiederum möglichst gering gehalten werden.

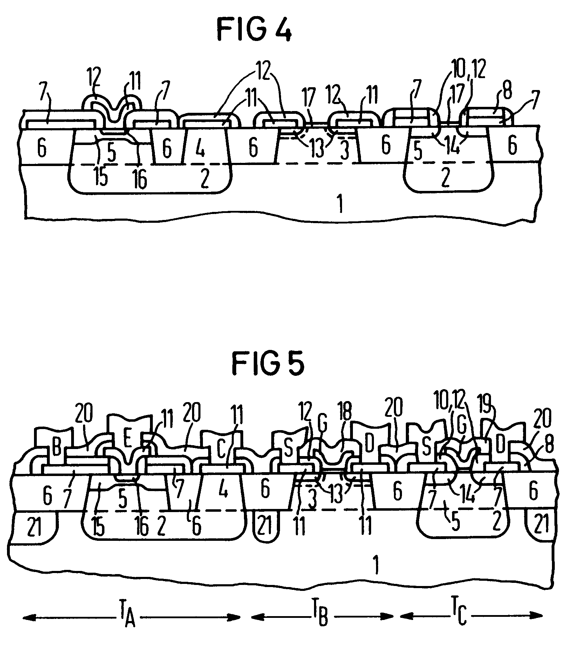

Figur 4: Nun erfolgt eine selektive Oxidation der Polysilizium-bzw. Silizidoberfläche (Schichtstruktur 11), welche bevorzugt in feuchter Atmosphäre und gegebenenfalls unter Hochdruck, beispielsweise im Bereich von 10 bar (900 bis 950°C) durchgeführt wird. Bei dieser Oxidation, bei der das Oxid auf n⁺-Bereichen deutlich dicker (ca. Faktor 3) als auf n- oder p-dotierten Gebieten aufwächst, wird zum einen die der Flankenisolation (Oxid-Spacer 2) dienende Oxidschicht 12 gebildet und zum anderen durch Ausdiffusion aus den p⁺- bzw. n⁺-dotierten Schichtstrukturen 7, 11 die im Substrat (1, 3, 5) gelegenen Zonen von Emitter 16, Basisanschluß 15 und Source/Drain 13, 14 erzeugt. Anschließend werden die Gate-Bereiche der MOS-Transistoren T_{B} und T_{C} von dem dünnen Oxid, welches dort bei der selektiven Oxidation aufgewachsen ist, befreit. Dabei wird die Breite der Isolationsstege 10, 12 (spacer oxid 1 + 2) an den Flanken der dotierten Strukturen 7, 11 durch speziell ausgewählte Ätzverfahren (isotrop oder anisotrop) eingestellt; die Breite bestimmt die Gatelänge und damit die Kanallänge der CMOS-Transistoren. Als Ätzverfahren kommen hier Trockenätzverfahren wie reaktives Ionenätzen, zum Beispiel in einem CHF₃/O₂ Gasgemisch oder naßchemische Ätzung (isotrop) in Frage. Dann wird das Gateoxid 17 in definierter Schichtdicke (ca. 25 nm) aufgebracht.

Figur 5 zeigt die fertige Anordnung mit Metallisierung nach erfolgter Kanal-Implantation, Abscheidung (gegebenenfalls Dotierung) und Strukturierung der Gate-Elektroden 18, 19 (nach vorheriger Maskierung der übrigen Bereiche), Erzeugung einer als Isolationsoxid dienenden Zwischenschicht 20, Öffnen der Kontaktlöcher zu den, aus den p⁺- bzw. n⁺-leitenden Strukturen 7, 11 bestehenden Anschlüssen zu dem Basisbereich, Emitterbereich, Kollektorbereich, Erzeugung von Basiskontakt B, Emitterkontakt E, Kollektorkontakt C sowie Source/Drain-Anschlüssen (S/D) und der Gate-Elektroden G. Letztere sind bekannte Standardprozesse.

In Figur 5 sind außerdem die bereits bei der Beschreibung der Figur 1 erwähnten, unter den Feldoxidbereichen 6 erzeugten "channel stopper"-Bereiche 21 eingezeichnet. Sie haben die Funktion, für eine sichere Isolation zwischen benachbarten Kollektorgebieten zu sorgen, indem die Einsatzspannung des parasitären Dickoxidtransistors auf Werte oberhalb der maximalen Betriebsspannung erhöht wird.

## Patentansprüche

1. Verfahren zum gleichzeitigen Herstellen von bipolaren (T_{A}) und komplementären MOS-Transistoren (T_{B}, T_{C}) auf einem gemeinsamen Siliziumsubstrat (1), bei dem für die Aufnahme der p-Kanal-Transistoren (T_{C}) im p-dotierten Siliziumsubstrat (1) n-dotierte Bereiche (5) erzeugt werden und in die n-dotierten Bereiche (5) isolierte npn Bipolartransistoren (T_{A}) gelegt werden, wobei die n-Bereiche (5) den Kollektor des Transistors (T_{A}) bilden und bei dem die n-Bereiche (5) vergrabene n⁺-dotierte Zonen (2) bedecken, die im Bipolar-Transistorbereich (T_{A}) durch tiefreichende Kollektoranschlüsse (4) angeschlossen werden, **gekennzeichnet durch** den Ablauf folgender Verfahrensschritte:
a) Herstellen der vergrabenen n⁺-dotierten Zonen (2) im p-dotierten Substrat (1) durch Implantation von n-dotierenden Ionen nach vorheriger Maskierung der übrigen Bereiche,
b) ganzflächiges Aufbringen einer p- oder n-dotierten Epitaxieschicht,
c) Aufbringen einer aus Siliziumoxid und Siliziumnitrid bestehenden Doppelschicht und entsprechende Strukturierung der Siliziumnitridschicht für eine nachfolgende lokale Oxidation,
d) Herstellung des für die Trennung der aktiven Transistorbereiche (T_{A}, T_{B}, T_{C}) im Substrat (1) erforderlichen Feldoxids (6) durch lokale Oxidation nach Entfernung der Photolackmaske und unter Verwendung der Siliziumnitrid-Struktur als Oxidationsmaske,
e) Erzeugen von n-Bereichen (5) zur Aufnahme der npn-Bipolartransistoren (T_{A}) und der p-Kanal-Transistoren (T_{C}) bzw. von p-Bereichen (3) zur Aufnahme der n-Kanal-Transistoren (T_{B}) im Substrat (1) durch Implantation von n- bzw. p-dotierenden Ionen sowie der Bereiche für den tiefreichenden Kollektoranschluß (4) durch eine Tiefimplantation mit n-dotierenden Ionen und Eindiffusion,
f) Entfernen der Nitrid/Oxidmaske,
g) ganzflächige Abscheidung einer p⁺-leitenden Schicht (7) aus bordotiertem Polysilizium, bordotiertem Metallsilizid oder einer bordotierten Doppelschicht aus Polysilizium und Metallsilizid,
h) ganzflächige Abscheidung einer ersten Isolatorschicht (8),
i) Durchführung einer Photolacktechnik und Strukturierung der p⁺-leitenden Schicht (7) und der ersten Isolatorschicht (8) mit senkrechten Flanken bis zur Freilegung des Substrats (1) mittels eines Trockenätzverfahrens zur Definition des Basisbereiches der Bipolartransistoren (T_{A}) und der Source/Drain-Bereiche der p-Kanal-Transistoren (T_{C}),
j) Durchführung einer Photolacktechnik zur Herstellung des aktiven Basisbereiches (9) durch Bor-Ionenimplantation,
k) ganzflächige Abscheidung einer die Strukturen der p⁺-leitenden Schicht (7) und der ersten Isolatorschicht (8) gut kantenbedeckenden zweiten Isolatorschicht,
l) Durchführung eines anisotropen Ätzprozesses zur Erzeugung von lateralen Isolationsstegen (10) aus der zweiten Isolatorschicht an den Flanken der p⁺-leitenden Schichtstrukturen (7),
m) ganzflächige Abscheidung einer n⁺-leitenden Schicht (11) aus Polysilizium, Metallsilizid oder einer Doppelschicht aus Polysilizium und Metallsilizid,
n) Durchführung einer Photolacktechnik und Strukturierung der n⁺-leitenden Schicht (11) so, daß die Source/Drain-Anschlüsse der n-Kanal-Transistoren (T_{B}) und der Emitter- und Kollektoranschluß der Bipolartransistoren (T_{A}) auf dem Substrat (1) gebildet werden,
o) Durchführung eines Hochtemperaturschrittes, wobei die freiliegenden Oberflächen der n⁺-leitenden Schichtstrukturen (11) mit einer unterschiedlich dicken, von der Dotierung abhängigen Oxidschicht (12) versehen werden und die Source/DrainZonen (13, 14) der MOS-Transistoren (T_{B}, T_{C}) sowie die Basis- und Emitterzone (15, 16) der Bipolar-Transistoren (T_{A}) durch Ausdiffusion aus den p⁺- bzw. n⁺-leitenden Strukturen (7, 11) gebildet werden,
p) Freiätzen der Gatebereiche der MOS-Transistoren (T_{B}, T_{C}), wobei die Dicke der an den Flanken der p⁺- bzw. n⁺-leitenden Strukturen (7, 11) befindlichen, den Gatebereichen benachbarten Oxidstege (10, 12) auf die gewünschten Gatelängen der MOS-Transistoren (T_{B}, T_{C}) eingestellt werden,
q) Aufwachsen des Gateoxids (17),
r) Durchführung einer ganzflächigen Kanalimplantation mit Bor-Ionen,
s) Abscheidung, Dotierung und Strukturierung der jeweiligen Gate-Elektroden (18, 19),
t) ganzflächige Erzeugung einer als Isolationsoxid dienenden Zwischenschicht (20) an der Oberfläche der Struktur, Öffnen der Kontaktlöcher zu den, aus den p⁺- bzw. n⁺-leitenden Strukturen (7, 11) bestehenden Anschlüssen der aktiven Transistorbereiche (B = Basis, E = Emitter, C = Kollektor und S = Source, D = Drain G = Gate) und Durchführung der Metallisierung.

2. Verfahren nach Anspruch 1, **dadurch gekennzeichnet,** daß als Isolatorschicht (8, 10, 12) nach Verfahrensschritt h) und k) eine SiO₂-Schicht verwendet wird.

3. Verfahren nach Anspruch 1 oder 2, **dadurch gekennzeichnet,** daß als Dotierstoff der n⁺-leitenden Schicht (11) Arsen mit einer Konzentration von größer 10²⁰ cm⁻³ verwendet wird, und daß die Dotierung während der Abscheidung nach Verfahrensschritt m) eingebracht wird.

4. Verfahren nach einem der Ansprüche 1 bis 3, **dadurch gekennzeichnet,** daß zwischen den Verfahrensschritten m) und n) nach erfolgter Photolacktechnik eine Phosphor-Ionen-Implantation im Bereich der n-Kanal-Transistoren (T_{B}) durchgeführt wird.

5. Verfahren nach einem der Ansprüche 1 bis 4, **dadurch gekennzeichnet,** daß die Hochtemperaturbehandlung nach Verfahrensschritt o) in feuchter Atmosphäre, insbesondere bei hohem Druck, durchgeführt wird.

6. Verfahren nach einem der Ansprüche 1 bnis 5, **dadurch gekennzeichnet,** daß im Anschluß an Verfahrensschritt c) in den späteren Feldoxidbereichen (6) eine Siliziumtiefätzung zur Erzielung einer planaren Oberfläche durchgeführt wird.

7. Verfahren nach einem der Ansprüche 1 bis 5, **dadurch gekennzeichnet,** daß anstelle der Verfahrensschritte c) und d) zur Trennung der aktiven Transistorbereiche Gräben in das Substrat (1) geätzt werden, die mit dielektrischem Material aufgefüllt werden.

8. Verfahren nach einem der Ansprüche 1 bis 6, **dadurch gekennzeichnet,** daß vor dem Verfahrensschritt d) durch Bor-Ionenimplantation unter den Feldoxidbereichen (6) channel-stopper-Bereiche (21) erzeugt werden.

## Claims

1. Process for simultaneously producing bipolar (T_{A}) and complementary MOS transistors (T_{B}, T_{C}) on a common silicon substrate (1), in which n-doped regions (5) are produced in the p-doped silicon substrate (1) to receive the p-channel transistors (T_{C}) and insulated n-p-n bipolar transistors (T_{A}) are laid down in the n-doped regions (5), the n-regions (5) forming the collector of the transistor (T_{A}), and in which the n-regions (5) cover buried n⁺-doped zones (2) which are connected by deep-reaching collector connections (4) in the bipolar transistor region (T_{A}), characterised by the following process step sequence:
a) production of the buried n⁺-doped zones (2) in the p-doped substrate (1) by implantation of n-doping ions after prior masking of the other regions,
b) application of a p- or n-doped epitaxial layer over the entire surface,
c) deposition of a double layer comprising silicon oxide and silicon nitride and suitable patterning of the silicon nitride layer for a subsequent local oxidation,
d) production of the field oxide (6) necessary in the substrate (1) to isolate the active transistor regions (T_{A}, T_{B}, T_{C}) by local oxidation after removing the photoresist mask and using the silicon nitride structure as an oxidation mask,
e) production of n-type regions (5) for receiving the n-p-n bipolar transistors (T_{A}) and the p-channel transistors (T_{C}), or of p-type regions (3) for receiving the n-channel transistors (T_{B}), in the substrate (1) by implantation of n- or p-doping ions and production of the regions for the deep-reaching collector connection (4) by a deep implantation of n-doping ions and drive-in,
f) removal of the nitride/oxide mask,
g) deposition of a p⁺-type layer (7) composed of boron-doped polysilicon, boron-doped metal silicide or a boron-doped double layer composed of polysilicon and metal silicide over the entire surface,
h) deposition of a first insulating layer (8) over the entire surface,
i) carrying out of a photoresist procedure and patterning of the p⁺-type layer (1) and of the first insulating layer (8) with vertical edges by means of a dry etching process until the substrate (1) is laid bare in order to define the base region of the bipolar transistors (T_{A}) and the source/drain regions of the p-channel transistors (T_{C}),
j) carrying out of a photoresist procedure to produce the active base region (9) by boron ion implantation,
k) deposition of a second insulating layer which provides good edge coverage for the structures of the p⁺-type layer (7) and the first insulating layer (8),
l) carrying out of an anisotropic etching process to produce lateral insulation strips (10) from the second insulating layer at the edges of the p⁺-type layer structures (7),
m) deposition of an n⁺-type layer (11) composed of polysilicon, metal silicide or a double layer composed of polysilicon and metal silicide over the entire surface,
n) carrying out of a photoresist procedure and patterning the n⁺-type layer (11) so that the source/drain connections of the n-channel transistors (T_{B}) and the emitter connection and collector connection of the bipolar transistors (T_{A}) are formed on the substrate (1),
o) carrying out of a high-temperature step in which the surfaces laid bare of the n⁺-type layer structures (11) are provided with a doping-dependent oxide layer (12) of various thicknesses and the source/drain zones (13, 14) of the MOS transistors (T_{B}, T_{C}), and the base and emitter zone (15, 16) of the bipolar transistors (T_{A}) are formed by outdiffusion from the p⁺- and n⁺-type structures (7, 11),
p) exposure of the gate regions of the MOS transistors (T_{B}, T_{C}) by etching, the thickness of the oxide strips (10, 12) situated at the edges of the p⁺-type and n⁺-type patterns (7, 11), respectively, and adjacent to the gate regions being adjusted to the desired gate lengths of the MOS transistors (T_{B}, T_{C}),
q) growing of the gate oxide (17),
r) carrying out of a channel implantation using boron ions over the entire surface,
s) deposition, doping and patterning of the respective gate electrodes (18, 19),
t) production of an interlayer (20) serving as an insulating oxide over the entire surface at the surface of the structure, opening of the vias to the active transistor region connections comprising the p⁺- and n⁺-type structures (7, 11) (B = base, E = emitter, C = collector and S = source, D = drain, G = gate) and carrying out the metallisation.

2. Process according to Claim 1, characterised in that an SiO₂ layer is used as insulating layer (8, 10, 12) according to process step h) and k).

3. Process according to Claim 1 or 2, characterised in that arsenic having a concentration of more than 10²⁰ cm⁻³ is used as dopant for the n⁺-type layer (11), and in that the doping is introduced during the deposition according to process step m).

4. Process according to one of Claims 1 to 3, characterised in that a phosphorus ion implantation is carried out in the region of the n-channel transistors (T_{B}) between the process steps m) and n) after the photoresist procedure has been carried out.

5. Process according to one of Claims 1 to 4, characterised in that the high-temperature treatment according to process step o) is carried out in a moist atmosphere, in particular at high pressure.

6. Process according to one of Claims 1 to 5, characterised in that a silicon deep etching is carried out in the subsequent field oxide regions (6) to achieve a planar surface following process step c).

7. Process according to one of Claims 1 to 5, characterised in that, instead of process steps c) and d) trenches which are filled with dielectric material are etched in the substrate (1) to isolate the active transistor regions.

8. Process according to one of Claims 1 to 6, characterised in that channel stopper regions (21) are produced underneath the field oxide regions (6) prior to process step d) by boron ion implantation.

## Revendications

1. Procédé de fabrication simultanée de transistors bipolaires (T_{A}) et de transistors MOS complémentaires (T_{B}, T_{C}) sur un substrat en silicium (1) commun, dans lequel des zones (5) dopées n sont créées dans le substrat de silicium (1) dopé p pour la réception des transistors (T_{C}) à canal p et dans lequel des transistors bipolaires npn (T_{A}) isolés sont placés dans les zones (5) dopées n , les zones n (5) formant le collecteur du transistor (T_{A}) et dans lequel les zones n (5) recouvrent des zones (2) ensevelies dopées n⁺, qui sont reliées dans la zone des transistors bipolaires (T_{A}), par l'intermédiaire d'un contact collecteur (4) s'étendant profondément, caractérisé par le déroulement des phases opératoires suivantes :
a) réalisation des zones (2) ensevelie dopées n⁺ dans le substrat (1) dopé p par implantation d'ions dopants n après masquage des autres zones,
b) dépôt en pleine surface d'une couche épitaxiale dopée p ou n,
c) dépôt d'une double couche composée d'oxyde de silicium et de nitrure de silicium et structuration correspondante de la couche de nitrure de silicium pour une post-oxydation locale,
d) réalisation de l'oxyde de champ (6) nécessaire à la séparation des zones actives des transistors (T_{A}, T_{B}, T_{C}), nécessaire dans le substrat (1) par oxydation locale après suppression du masque de photoresist et avec utilisation de la structure en nitrure de silicium comme masque d'oxydation,
e) production dans le substrat (1), de zones n (5) pour la réception des transistors bipolaires npn (T_{A}) et des transistors à canal p (T_{C}), et de zones p (3) pour la réception de transistors à canal n (T_{B}), par implantation d'ions dopés n et p, ainsi que les zones pour le contact collecteur (4) s'étendant profondément, par une implantation profonde avec des ions dopés n et une diffusion en profondeur,
f) suppression du masque d'oxyde/niture,
g) dépôt en pleine surface d'une couche (7) de conductivité p⁺ de polysilicium dopé au bore, de siliciure métallique dopé au bore ou d'une double couche de polysilicium et de siliciure métallique dopée au bore,
h) dépôt en pleine surface d'une première couche isolante (8),
i) exécution d'une technique photoresist et structuration de la couche (7) de conductivité p⁺ et de la première couche isolante (8) avec des flancs verticaux jusqu'à dégagement du substrat (1) au moyen d'un procédé d'attaque par voie sèche, pour définir la zone de base des transistors bipolaires (T_{A}) et des zones source-drain des transistors à canal p (T_{C}),
j) exécution d'une technique photoresist pour réaliser la zone active de base (9) par implantation d'ions bore,
k) dépôt en pleine surface d'une seconde couche isolante, recouvrant les structures de la couche (7) de conductivité p⁺ et recouvrant bien les bords de la première couche isolante (8),
l) exécution d'un processus anisotrope de gravure pour réaliser des barrettes isolantes latérales (10) de la seconde couche isolante sur les flancs des structures de couches (7) de conductivité p⁺,
m) dépôt en pleine surface d'une couche (11) de conductivité n⁺ de polysilicium, de siliciure métallique ou d'une double couche de polysilicium et de siliciure métallique,
n) exécution d'une technique photoresist et structuration de la couche (11) de conductivité n⁺ de manière que les bornes source-drain des transistors à canal n (T_{B}) et des bornes contacts émetteur et collecteur des transistors bipolaires (T_{A}) soient réalisées sur le substrat (1),
o) exécution d'une phase opératoire à température élevée, les surfaces dégagées des structures de couches (11) de conductivité n⁺ étant pourvues d'une couche d'oxyde (12) d'épaisseur différente en fonction du dopage et les zones drain source (13, 14) des transistors MOS (T_{B}, T_{C}) ainsi que les zones de base et d'émetteur (15, 16) des transistors bipolaires (T_{A}) étant formées par une diffusion extérieure à partir des structures (7, 11) de conductivité p⁺ ou n⁺,
p) dégagement par attaque des zones de grille des transistors MOS (T_{B}, T_{C}), les épaisseurs des barrettes d'oxyde (10, 12) voisines de la zone de grille et qui se situent au niveau des flancs des structures de couches (7, 11) de conductivité p⁺ ou n⁺, étant ajustées à la longueur de grille désirée des transistors MOS (T_{B}, T_{C}),
q) connaissance de l'oxyde de grille (17),
r) exécution en pleine surface d'une implantation de canal avec des ions bore,
s) dépôt, dopage et à structuration des électrodes de grille respectives (18, 19),
t) production en pleine surface, sur la surface de la structure, d'une couche intermédiaire (20) servant d'oxyde isolant, ouverture des trous de contact menant aux contacts, des zones actives des transistors (B = base, E = émetteur, C = collecteur et S = source, D = drain, G = grille) et constituées par les structures (7, 11) de conductivité p⁺ ou n⁺, et réalisation de la métallisation.

2. Procédé selon la revendication 1, caractérisé en ce qu'une couche de SiO₂ est utilisée comme couche isolante (8, 10, 12) selon les phases de procédé h) et k).

3. Procédé selon la revendication 1 ou 2, caractérisé en ce que l'arsenique est utilisé comme agent de dopage de la couche (11) de conductivité n⁺, avec une concentration supérieure à 10²⁰ cm⁻³, et en ce que le dopage est réalisé pendant le dépôt selon la phase de procédé m).

4. Procédé selon l'une des revendications 1 à 3, caractérisé en ce qu'une implantation d'ions phosphore est effectuée dans la zone des transistors à canal n (T_{B}) entre les deux phases de procédé m) et n), et après execution de la technique de photoresist.

5. Procédé selon l'une des revendications 1 à 4, caractérisé en ce que le traitement à haute température selon la phase de procédé O) est effectué dans une atmosphère humide et en particulier à haute pression.

6. Procédé selon l'une des revendications 1 à 5, caractérisé en ce que, à la suite de la phase de procédé c), on réalise une gravure profonde de silicium dans les zones (6) ultérieures d'oxyde de champ pour obtenir une surface plane.

7. Procédé selon l'une des revendications 1 à 5, caractérisé en ce que, à la place des phases de procédé c) et d), des sillons, qui sont remplis d'un matériau diélectrique, sont gravés dans le substrat (1) pour séparer les zones actives des transistors.

8. Procédé selon l'une des revendications 1 à 6, caractérisé en ce que, avant la phase de procédé d), des zones d'arrêt de canal (21) sont créées sous les zones d'oxyde de champ (6), par une implantation d'ions bore.
